(19) Europäisches Patentamt
European Patent Office
Office européen des brevets

(11) Veröffentlichungsnummer : **0 526 490 B1**

(12) # EUROPÄISCHE PATENTSCHRIFT

(45) Veröffentlichungstag der Patentschrift :
**20.07.94 Patentblatt 94/29**

(51) Int. Cl.$^5$ : **C09D 11/00,** // B41J2/01

(21) Anmeldenummer : **91907755.2**

(22) Anmeldetag : **10.04.91**

(86) Internationale Anmeldenummer :
**PCT/EP91/00677**

(87) Internationale Veröffentlichungsnummer :
**WO 91/17219 14.11.91 Gazette 91/26**

(54) **TEMPERATUR- UND LÖSEMITTELBESTÄNDIGE TINTE FÜR DAS STRAHLDRUCKVERFAHREN.**

(30) Priorität : **27.04.90 DE 4013456**

(43) Veröffentlichungstag der Anmeldung :
**10.02.93 Patentblatt 93/06**

(45) Bekanntmachung des Hinweises auf die Patenterteilung :
**20.07.94 Patentblatt 94/29**

(84) Benannte Vertragsstaaten :
**AT BE CH DE DK ES FR GB IT LI NL SE**

(56) Entgegenhaltungen :
**FR-A- 2 385 782**
**GB-A- 2 205 571**
**Patent Abstracts of Japan, vol.13, No. 174, 25 April 1989; & JP-A-10 04 676**
**Patent Abstracts of Japan, vol. 10, No. 107, 22 April 1986; & JP-A-60 235 860**

(73) Patentinhaber : **Dr. Beck & Co. AG**
**Postfach 28 01 80,**
**Grossmannstrasse 105**
**D-20514 Hamburg (DE)**

(72) Erfinder : **WERNER, Violetta**
**Eichredder 13 B**
**D-2000 Oststeinbek (DE)**
Erfinder : **HELLER, Hans-Joachim**
**Blankeneser Haupstrasse 62**
**D-2000 Hamburg 55 (DE)**
Erfinder : **LIENERT, Klaus-Wilhelm**
**Bernadottestrasse 54**
**D-2000 Hamburg 50 (DE)**

(74) Vertreter : **Münch, Volker, Dr.**
**BASF Lacke + Farben AG**
**Patente/Lizenzen/Dokumentation**
**Postfach 61 23**
**D-48136 Münster (DE)**

EP 0 526 490 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Gegenstand der vorliegenden Erfindung ist eine Tinte für das Strahldruckverfahren, enthaltend Bindemittel, organisches Lösungsmittel, Leitsalz, ggf. Pigmente und/oder Farbstoffe oder Fluoreszenzfarbstoffe sowie ggf. weitere Hilfs- und Zusatzstoffe.
Die Erfindung betrifft außerdem ein Verfahren zur Herstellung dieser Tinte, ein Verfahren zum Beschriften einer Oberfläche mittels des Strahldruckverfahrens unter Verwendung dieser Tinte sowie die Verwendung dieser Tinte zur Beschriftung thermisch und/oder chemisch belasteter Oberflächen.

Das Tintenstrahldruckverfahren ("ink jet printing") ist eine bekannte Methode, mittels derer berührungsfrei verschiedene Substrate beschichtet werden können. Dieses Verfahren ist für eine Vielzahl von Substraten aus den unterschiedlichsten Materialien einsetzbar.
An die in diesem Strahldruckverfahren einsetzbaren Tinten werden hohe Anforderungen, insbesondere hinsichtlich Viskosität, elektrischer Leitfähigkeit, Verträglichkeit der einzelnen Bestandteile der Tinte, Substratbenetzung, Trocknungsverhalten u.ä. gestellt.

Es sind bereits zahlreiche für dieses Strahldruckverfahren geeignete Tinten bekannt (vgl. z.B. US-PS 4,791,165, US-PS 4,352,901; US-PS 4,680,332; US-PS 4,465,800; EP-A-314 403; DE-OS 3 315 741; DE-OS 2 704 082). Diese Tinten enthalten üblicherweise neben organischen Lösungsmitteln ein oder mehrere Bindemittel, Leitsalze, ggf. Pigmente sowie ggf. weitere Hilfs- und Zusatzstoffe. Teilweise kommen sie auch in wäßriger Form zum Einsatz.
Als Bindemittel werden in den bekannten Tinten beispielsweise Phenolharze vom Resoltyp, Acrylat- und Methacrylatcopolymerisate, Maleinsäure/Styrol-Copolymerisate, Polyvinylalkoholpolymerisate, Vinylchlorid/Vinylidenchlorid-Copolymerisate, Cellulosederivate und Mischungen verschiedener Polymerisate eingesetzt.

Die aus dem Stand der Technik bekannten Tinten weisen jedoch den Nachteil auf, daß die resultierenden Beschriftungen nur eine unzureichende thermische Stabilität sowie eine nur unzureichende chemische Beständigkeit, beispielsweise gegenüber Methylethylketon, Ethanol, Isopropanol, Freo® TP 35 u.ä. zeigen. Gerade diese Beständigkeiten werden aber beispielsweise von Beschriftungen elektronischer Bauteile, wie z.B. Kupferplatten, Leiterplatten, Keramikwiderständen, Kabeln, Polyamid-Spritzgußteilen u.ä. gefordert. Verbesserungsbedürftig ist außerdem die Haftung der resultierenden Beschriftungen auf problematischen Substraten, wie beispielsweise Kupfer-, Keramik- und Glasoberflächen sowie auf Kabelummantelungen u.ä.

Der vorliegenden Erfindung liegt somit die Aufgabe zugrunde, eine für das Strahldruckverfahren geeignete Tinte zur Verfügung zu stellen, die zu Beschriftungen mit einer guten thermischen Belastbarkeit, guter Chemikalienbeständigkeit sowie guter Haftung auf problematischen Untergründen führt.

Diese Aufgabe wird überraschenderweise durch eine Tinte für das Strahldruckverfahren, enthaltend Bindemittel, organisches Lösungsmittel, Leitsalz, ggf. Pigmente und/oder Farbstoffe oder Fluoreszenzfarbstoffe sowie ggf. weitere Hilfs- und Zusatzstoffe, gelöst. Die Tinte ist dadurch gekennzeichnet, daß sie

A) 1 bis 30 Gew.-% einer oder mehrerer Polyamidocarbonsäuren oder eines oder mehrerer in organischen Lösungsmitteln löslicher Polyimide,
B) 60 bis 98,8 Gew.-% mindestens eines organischen Lösungsmittels,
C) 0,1 bis 3 Gew.-% mindestens eines Leitsalzes,
D) ggf. Pigmente, Farbstoffe oder Fluoreszenzfarbstoffe und
E) ggf. weitere Hilfs- und Zusatzstoffe

enthält, wobei alle Mengenangaben auf das Gesamtgewicht der Tinte bezogen sind.

Gegenstand der vorliegenden Erfindung ist außerdem ein Verfahren zur Herstellung dieser Tinte, ein Verfahren zum Beschriften einer Oberfläche mittels des Strahldruckverfahrens unter Verwendung dieser Tinte sowie die Verwendung dieser Tinte zur Beschriftung thermisch und/oder chemisch belasteter Oberflächen.
Es ist überraschend und war nicht vorhersehbar, daß Lösungen von Polyamidocarbonsäuren bzw. Polyimiden als Tinten für das Strahldruckverfhren einsetzbar sind, insbesondere im Hinblick auf die zu erwartenden Schwierigkeiten beim Lösen der Leitsalze. Überraschend ist diese Verwendungsmöglichkeit der Polyamidocarbonsäuren bzw. Polyimide auch insofern, als an für das Strahldruckverfahren geeignete Tinten hohe Anforderungen bezüglich Viskosität, elektrischer Leitfähigkeit, Verträglichkeit der einzelnen Komponenten der Tinte, der Substratbenetzung, des Trocknungsverhaltens u.ä. gestellt werden und es aus dem Stand der Technik nicht bekannt war und auch nicht nahegelegt wurde, daß Tinten mit diesem anspruchsvollen Eigenschaftsprofil auch auf Basis von Polyamidocarbonsäuren bzw. Polyimiden formuliert werden können.
Die erfindungsgemäßen Tinten weisen insbesondere den Vorteil einer hervorragenden thermischen und chemischen Belastbarkeit der resultierenden Beschriftungen auf. Weiterhin zeichnen sich die resultierenden Beschriftungen durch eine gute Haftung auch auf problematischen Untergründen, wie z.B. Glas-, Kupfer-, Aluminium-, Keramik- und Kunststoffoberflächen aus.

Im folgenden werden nun zunächst die einzelnen Bestandteile der erfindungsgemäßen Tinte näher erläutert.

Als erfindungswesentlichen Bestandteil enthalten die Tinten als Bindemittel-Komponente A eine oder mehrere Polyamidocarbonsäuren oder ein oder mehrere in organischen Lösungsmitteln lösliche Polyimide. Das Bindemittel wird in den Tinten in einer Menge von 1 bis 30 Gew.-%, bevorzugt 2 bis 15 Gew.-%, bezogen auf das Gesamtgewicht der Tinte, eingesetzt.

Die verwendeten Polyamidocarbonsäuren sind bekannt und sind beispielsweise in der GB-PS 898,651, der US-PS 3,207,728 und der US-PS 3,234,181 beschrieben. Die bekannten Polyamidocarbonsäuren werden üblicherweise als Drahtlacke und zur Chip-Herstellung eingesetzt. Hinweise auf den Einsatz oder die Eignung dieser Polyamidocarbonsäuren als Bindemittel in Tinten für das Strahldruckverfahren sind in diesen Schriften jedoch nicht enthalten.

Die Herstellung der Polyamidocarbonsäuren erfolgt in bekannter Weise (vgl. z.B. GB-PS 898.651) durch Umsetzung von primären Di-, Tri- oder Tetraminen mit Anhydriden oder Estern von Tetracarbonsäuren in geeigneten Lösungsmitteln.

Beispiele für geeignete primäre Diamine sind aliphatische diprimäre Diamine wie z.B. Ethylendiamin, Tetramethylendiamin, 1,2-Bis-(3-aminopropoxi)-ethan, 2,2-Dimethylpropylendiamin, Hexamethylendiamin, Heptamethylendiamin, Octamethylendiamin, Nonamethylendiamin, Decamethylendiamin, Dodecamethylendiamin, 3-Methylheptamethylendiamin, 4,4-Dimethylheptamethylendiamin, 2,11-Diaminododecan, 3-Methoxihexamethylendiamin, 2,2-Dimethylpropylendiamin, 2,5-Dimethylhexamethylendiamin, 2,5-Dimethylheptamethylendiamin, 5-Methylnonamethylendiamin, 2,17-Diaminoeicosadecan, 1,10-Diamino-1,10-dimethyldecan, 1,12-Diaminooctadecan; cycloaliphatische diprimäre Diamine wie z.B. 4,4′-Diaminodicyclohexylmethan, 1,4-Diaminocyclohexan; diprimäre aromatische Diamine wie z.B. Benzidin, 4,4′-Diaminodiphenylmethan, 4,4′- bzw. 3,3′-Diaminodiphenylpropan, 4,4′- bzw. 3,3′-Diaminodiphenylketon, -oxid, -sulfon, -sulfid, -sulfoxid, -ether und -thioether, Phenylendiamine, Toluylendiamine, Xylylendiamine, 1,5-Diaminonaphthalin, 3,3′-Dimethoxibenzidin, 3,3′-Dimethyl-4,4′-diphenyldiamin, 2,4-Bis(beta-amino-t-butyl)-toluol, Bis-(parabeta-amino-t-butylphenyl)-ether, Bis-(parabeta-methyldelta-aminopentyl)-benzol, 1-Isopropyl-2,4-metaphenylendiamin, Bis-para-(1,1′-dimethyl-5-amino-pentyl)-benzol, 2,6-Diaminopyridin und Bis-(4-aminophenyl)-methylphosphinoxid sowie auch Diamine mit drei Benzolkernen im Molekül wie Bis(4-aminophenyl)-α,α′-p-Xylol, Bis-(4-aminophenoxi)-1,4-benzol oder Bis-(4-aminophenyl)-phenylphosphinoxid.

Die primären Tri- und Tetramine sind vorzugsweise Verbindungen, bei denen die $NH_2$-Gruppen von einem Benzol-, Naphthalin-, Pyridin- oder einem Triazinring getragen werden. Sie können auch von mehreren Benzolringen getragen werden, die untereinander durch verschiedene Alkyl-, Aryl-, Ether-, Sulfon-, Sulfid-, Phosphatgruppen u.a. verbunden sind. Als Beispiele für solche Amine kann man die folgenden nennen: 1,2,4-Triaminobenzol, 1,2,3-Triaminobenzol, 1,3,5-Triaminobenzol, 2,4,6-Triaminotoluol, 2,4,6-Triamino-1,3,5-trimethylbenzol, 1,3,7-Triaminonaphthalin, 2,4,4′-Triaminodiphenyl, 2,4,6-Triaminopyridin, 2,4,4′-Triaminophenylether, 2,4,4′-Triaminodiphenylmethan, 2,4,4′-Triaminodiphenylsulfon, 2,4,4′Triaminobenzophenon, 2,4,4′-Triamino-3-methyldiphenylmethan, N,N,N-Tri-(4-aminophenyl)-amin, Tri-(4-aminophenyl)-methan, Phenyl-4,4′-4″-triaminoorthophosphat, Tri-(4-aminophenyl)-phosphinoxid, 3,5,4′-Triaminobenzanilid, Melamin, 3,5,3′,5′Tetraaminobenzophenon, 1,2,4,5-Tetraaminobenzol, 2,3,6,7-Tetraaminonaphthalin, 3,3′-Diaminobenzidin, 3,3′,4,4′-Tetraaminophenylether, 3,3′,4,4′-Tetraaminodiphenylmethan, 3,3′,4,4′-Tetraaminodiphenylsulfon, 3,5-Bis(3,4′-diaminophenyl)-pyridin.

Für die Darstellung der Polyamidocarbonsäuren geeignete Carbonsäureanhydride sind z.B. Pyromellithsäuredianhydrid, Naphthalintetracarbonsäuredianhydride, Dianhydride von Tetracarbonsäuren mit 2 Benzolkernen im Molekül, bei denen die Carboxylgruppen in 3,3′,4,4′-Stellung stehen, wie z.B. 3,3′4,4′-Diphenyltetracarbonsäuredianhydrid, Benzophenon-3,3′,4,4′-tetracarbonsäureanhydrid, Bis-(3,4′-dicarboxiphenyl)-etherdianhydrid, 2,2-Bis-(3,4-dicarboxiphenyl)-propandianhydrid sowie Thiophentetracarbonsäureanhydrid.

Geeignete Lösemittel für die Darstellung der Polyamidocarbonsäuren sind solche organischen Verbindungen, deren funktionelle Gruppen nicht in größerem Umfang mit den Amin- und Anhydridgruppen der Ausgangsstoffe reagieren und die mindestens entweder das Amin oder das Anhydrid, bevorzugt sowohl beide Ausgangsverbindungen als auch die entstehende Amidocarbonsäure, lösen. Beispiele sind N,N-Dimethylformamid, N,N-Dimethylacetamid, N,N-Diethylformamid, N,N-Diethylacetamid, N,N-Dimethylmethoxiacetamid, N-Methylcaprolactam, Dimethylsulfoxid, N-Methylpyrrolidon, Tetramethylharnstoff, Pyridin, Formamid, N-Methylformamid, N-Acetylpyrrolidon, Dimethylsulfon, Tetramethylensulfon und Hexamethylphosphoramid. 10 bis 30%ige Lösungen der hergestellten Polyamidocarbonsäuren weisen im allgemeinen bei 23°C Viskositäten von 2.000 bis 7.000 mPas auf.

Die Polyamidocarbonsäuren sind thermisch mit oder ohne Zusatz entwässernder Mittel durch Cyclisierung in die Polyimide überführbar.

Weiterhin als Bindemittel geeignet sind in organischen Lösungsmitteln lösliche Polyimide, wie sie beispielsweise in der EP-B-77717 beschrieben sind. Die Herstellung der löslichen Polyimide erfolgt in bekannter Weise durch Umsetzung von primären Di-, Tri- oder Tetraminen mit Anhydriden oder Estern von Tetracarbonsäuren in geeigneten Lösungsmitteln, wobei die Löslichkeit der Polyimide durch Einstellung der Reaktionsbedingungen und/oder Auswahl geeigneter Aufbaukomponenten erzielt wird. Wegen näherer Einzelheiten wird auf die oben genannte Literatur verwiesen. Bevorzugt werden Polyamidocarbonsäuren bzw. Polyimide auf der Basis von 4,4′-Diaminodiphenyloxid und/oder Benzidin und/oder Benzophenon-3,3′,4,4′-tetracarbonsäuredianhydrid und/oder Pyromellithsäureanhydrid eingesetzt.
Als weiteren Bestandteil enthalten die erfindungsgemäßen Tinten mindestens ein organisches Lösungsmittel. Das Lösungsmittel wird üblicherweise in einer Menge von 60 bis 98,8 Gew.-%, bevorzugt von 79,5 bis 97,6 Gew.-%, jeweils bezogen auf das Gesamtgewicht der Tinte, eingesetzt. Durch die Art und die mengenmäßige Zusammensetzung des Lösungsmittels bzw. Lösungsmittelgemisches werden, ggf. in Verbindung mit dem Bindemittel, insbesondere die Viskosität der Tinte sowie die Löslichkeit der Leitsalze beeinflußt bzw. gesteuert. Beispiele für geeignete Lösungsmittel sind N-Methylpyrrolidon, N,N-Dimethylformamid, N,N-Dimethylacetamid, Alkylencarbonate der Formel

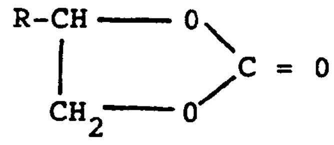

wobei R entweder Wasserstoff oder einen aliphatischen, aromatischen oder alkylaromatischen Rest darstellt, wie z.B. Ethylencarbonat, Propylencarbonat, Isobutylencarbonat sowie Mischungen dieser Lösungsmittel. Gegebenenfalls können zusammen mit diesen genannten Lösungsmittel noch aromatische, aliphatische und/oder cycloaliphatische Kohlenwasserstoffe als Verschnittmittel eingesetzt werden. Hierfür sind beispielsweise Xylol, Toluol, Solventnaphth®, verschiedene Solvesso®-Typen, verschiedene Shellsol®-Typen, Deasol®, verschiedene Testbenzine u.ä. geeignet.

Im Unterschied zu den stark wasserstoff-gebundenen Verdünnungsmitteln, wie z.B. Wasser, in denen die gewünschte Leitfähigkeit bereits durch Zugabe des Farbstoffs erhalten wird, erfordern die erfindungsgemäß eingesetzten Lösungsmittel den Zusatz eines Leitsal-zes (ionisierbares Salz) zur Einstellung der - für den Einsatz in dem Strahldruckverfahrenerforderlichen Leitfähigkeit der Tinten.
Als Leitsalze werden ionisierbare anorganische oder organische Salze, beispielsweise Alkali- und Erdalkalihalogenide, -nitrate, -thiocyanate, -acetate, -propionate und -aminsalze eingesetzt. Beispiele für geeignete Verbindungen sind Lithium-, Natrium-, Kalium- oder Ammoniumchlorid, Ammoniumnitrit, Lithiumnitrat, Lithiumperchlorat Trihydrat, Hydroxylaminhydrochlorid, Dimethylaminhydrochlorid, Alkali- und Ammoniumacetat, Kaliumrhodanid u.ä. Es können auch Mischungen verschiedener Leitsalze eingesetzt werden. Bevorzugt werden Lithiumperchlorat Trihydrat und Ammoniumacetat eingesetzt.

Die Leitsalze können dabei den Tinten direkt oder auch in Form einer Lösung in einem geeigneten organischen Lösungsmittel zugesetzt werden. Der Leitsalzgehalt der Tinten wird so gewählt, daß eine für den Einsatz in dem Strahldruckverfahren ausreichende elektrische Leitfähigkeit der Tinte resultiert. Die hierfür jeweils erforderliche Menge hängt von der jeweiligen Zusammensetzung der Tinte ab und liegt im allgemeinen zwischen 0,1 bis 3 Gew.-%, bevorzugt zwischen 0,2 und 1,5 Gew.-%, jeweils bezogen auf das Gesamtgewicht der Tinte.

Die erfindungsgemäßen Tinten können ggf. noch Pigmente, Farbstoffe oder Fluoreszenzfarbstoffe in üblichen Mengen, bevorzugt in Mengen von 0,1 bis 5,0 Gew.-%, bevorzugt von 0,2 bis 3,0 Gew.-%, jeweils bezogen auf das Gesamtgewicht der Tinte, enthalten.
Zur Einstellung der gewünschten Farbe ist eine Vielzahl von Pigmenten, Farbstoffen und Fluoreszenzfarbstoffen geeignet. So können als Pigmente beispielsweise Titandioxid, Ruß, Eisenoxide u.ä. eingesetzt werden. Als lösliche Farbstoffe können beispielsweise Azofarbstoffe, Xanthen-Farbstoffe u.ä. eingesetzt werden, beispielsweise die unter Markenamen BASONYL® Rot 540 der Firma BASF AG, Ludwigshafen und FASTUSOL® Blau 31 L der BASF AG, Ludwigshafen im Handel erhältlichen Produkte. Beispiele für geeignete Fluoreszenzfarbstoffe sind die im Handel erhältlichen Produkte Lumilux® Blau CD 312, Lumilux® Blaugrün CD 301 und Lumilux® Rot CD 303 der Firma Riedel-de Haën.

Gegebenenfalls können die erfindungsgemäßen Tinten noch weitere Hilfs- und Zusatzstoffe in üblichen Mengen, bevorzugt von 0,01 bis 5,0 Gew.-%, besonders bevorzugt von 0,02 bis 1,0 Gew.-%, jeweils bezogen auf das Gesamtgewicht der Tinte, enthalten. So können den Tinten beispielsweise zur Verbesserung des Verlaufs und zur Verbesserung des optischen Eindrucks der resultierenden Beschriftung perfluorierte Ester sowie Füllstoffe, wie beispielsweise Siliciumdioxid, verschiedene Silikate, Glimmer, Talkum, Kaolin, Kreide,

Quarzmehl, Schiefermehl, Bariumsulfat, verschiedene Kieselsäuren und dgl. zugesetzt werden.
Entsprechend den Anforderungen an eine für das Strahldruckverfahren geeignete Tinte weisen die erfindungsgemäßen Tinten bevorzugt folgende Parameter auf:

- Viskosität der Tinte bei 23°C 0,5 bis 90 mPas, besonders bevorzugt von 2 bis 20 mPas,
- spezifische Leitfähigkeit 300 bis 20.000 µS/cm, besonders bevorzugt von 700 bis 2500 µS/cm,
- mittlere Korngröße der unlöslichen Produkte < 10 µm, besonders bevorzugt < 3 µm,
- Schallgeschwindigkeit zwischen 900 und 2000 m/s.

Die Herstellung der erfindungsgemäßen Tinten erfolgt in üblicher Weise durch Vermischen der einzelnen Komponenten und ggf. Homogenisieren durch Dispergieren. Mitunter ist es angezeigt, eine Komponente, wie z.B. das Leitsalz, zunächst in einem geeigneten Lösungsmittel zu lösen und diese Lösung mit den übrigen Komponenten zu vermischen. Die Einarbeitung der Pigmente und Farbstoffe kann ebenfalls vorteilhafterweise in Form einer Paste oder Lösung bzw. Dispersion erfolgen. Das Strahldruckverfahren ist an sich bekannt, so daß wegen Einzelheiten auf die entsprechende Literatur verwiesen wird (vgl. z.B. Ullmanns Encyklopädie der technischen Chemie, 4. Auflage, Band 23: Textilhilfsmittel bis Vulkanfiber, Verlag Chemie, Weinheim-Deerfield Beach, Florida-Basel 1983, Seiten 259 bis 266).

Dieses Verfahren stellt eine äußerst vorteilhafte Methode zur Beschriftung von Oberflächen dar, da es leicht durchführbar ist und eine hohe Wirtschaftlichkeit aufweist. Die zur Durchführung des Verfahrens eingesetzten Anlagen sind in der Regel elektronisch gesteuert. Bei diesem Strahldruckverfahren wird die Tinte zunächst unter Druck vom Haupttank zum Schreibkopf befördert und mit hoher Geschwindigkeit aus der Düse gedrückt. Der entstehende Tintenstrahl wird durch Ultraschallanregung in Tropfen zerlegt. Diese zum Schreiben benutzten Tropfen werden elektrisch aufgeladen, abgelenkt und fliegen auf das zu bedruckende Produkt. Nicht benutzte Tropfen werden aufgefangen und wieder dem Haupttank zugeführt. Prinzipiell können mit Hilfe dieses Strahldruckverfahrens sowohl bewegte als auch stehende Güter beschriftet werden. Zur Beschriftung stehender Güter wird der Schreibkopf des Druckers elektronisch kontrolliert bewegt. Alternativ können auch bewegte Güter unter elektronischer Kontrolle beschriftet werden. Da die Tinte aus einer Spritzdüse berührungsfrei flüssig aufgebracht wird, ist die Art der zu beschriftenden Oberfläche unerheblich und es lassen sich so beliebig geformte Oberflächen unterschiedlicher Struktur kennzeichnen. Das Bedrucken kann daher auf einer ebenen, konkaven, konvexen, terrassenförmigen, geprägten, gerippten oder ähnlich unregelmäßig geformten Oberfläche erfolgen.

Die erfindunsggemäßen Tinten eignen sich hervorragend zur Beschriftung thermisch und chemisch belasteter Teile.
Weiterhin weisen sie den Vorteil einer guten Haftung auch auf problematischen Untergründen, wie z.B. Kupfer-, Keramik-, Glas- sowie Polyamidoberflächen, u.ä. auf. Sie werden daher bevorzugt zur Beschriftung von elektronischen Bauteilen, wie z.B. Leiterplatten, Drähten, Kabeln, Spritzgußteilen aus Polyamid, Keramikwiderständen usw. eingesetzt. Weiterhin sind die erfindungsgemäßen Tinten auch zur großflächigen Beschichtung bzw. der elektrischen Isolation von gedruckten Leiterplatten einsetzbar.

Die Trocknung der erfindungsgemäßen Beschriftung bzw. Beschichtung erfolgt durch Erhitzen der beschrifteten bzw. beschichteten Gegenstände im allgemeinen auf Temperaturen von 200 bis 400°C während einer Zeit von im allgemeinen 2 s bis 2 min.

Die Erfindung wird nun im folgenden anhand von Ausführungsbeispielen näher erläutert. Alle Angaben über Teile und Prozente sind dabei Gewichtsangaben, sofern nicht ausdrücklich etwas anderes festgestellt wird.

Herstellung einer Polyamidocarbonsäure

Die Polyamidocarbonsäure wird nach der in der GB-PS 898,651 beschriebenen Methode hergestellt aus:
40,0 Teilen 4,4'-Diaminodiphenyloxid
43,6 Teilen Pyromellithsäureanhydrid.
Eine 25%ige Lösung in N-Methylpyrrolidon (NMP) hat eine Viskosität von 3.000 mPas.

Beispiel 1

219,8 g der obenbeschriebenen 25 %igen Lösung der Polyamidocarbonsäure werden mit 659,4 g N-Methylpyrrolidon verdünnt. In 109,9 g Propylencarbonat werden 10,9 g Lithiumperchlorat Trihydrat gelöst. Die beiden Lösungen werden gemischt.
Die so erhaltene Tinte 1 hat eine Viskosität von 15 mPas bei 23°C und einen Festkörper von 6,25 % (Einwaage 2 g, 2 Stunden bei 200°C im Umluftofen). Die Leitfähigkeit beträgt 1220 µS/cm bei 23°C. Die Tinte 1 wird mit Hilfe des Farbstrahldruckers TSSG 102 der Firma Wiedenbach (Systemdruck 4,2 bar, Düsenweite 75 µm; Entfernung Tintenkopf/Objekt mindestens 15 mm) auf eine Kupferplatte aufgebracht.

Die Beschriftung wird anschließend durch Erhitzen mittels eines Ofens (Ofentemperatur 300°C) während einer Zeit von 30 s gehärtet.

Zur Prüfung der Eigenschaften der resultierenden Beschriftung werden folgende Untersuchungen durchgeführt:

1. Prüfung der Haftung nach der Tesafilm®- Abrißmethode:

Ein Tesafilm®-Streifen wird auf die Beschriftung gepreßt und danach abgerissen. Die Fläche der dabei vom Träger entfernten Beschriftung wird ermittelt und das Ergebnis benotet: 0 = 100 %, 1 = 90 %....und 5 < 20 % unbeschädigte Beschriftung.

2. Prüfung der Haftung mit der Fingernagel-Ritzprobe

Es wird untersucht, ob sich die Beschriftung durch Ritzen mit dem Fingelnagel entfernen läßt.

3. Prüfung der Lösemittelbeständigkeit

Ein mit dem jeweiligen Lösemittel (Methylethylketon, Ethanol, Isopropanol oder Freon® TP35) getränkter Wattebausch wird in regelmäßigen Doppelhüben über den Film bewegt. Die Auflagekraft ist ca. 20 N. Beurteilt wird die Lesbarkeit der Schrift nach 100 Doppelhüben. Außerdem wird die Lösemittelbeständigkeit durch Behandlung der beschrifteten Gegenstände für 15 min im Ultraschallbad mit Freon® T 35 geprüft, sofern der Untergrund selbst lösemittelbeständig ist.

4. Prüfung der thermischen Belastbarkeit

Die Prüfung der thermischen Belastbarkeit der resultierenden Beschriftungen erfolgt dadurch, daß das beschriftete Teil über längere Zeit einer erhöhten Temperatur ausgesetzt wurde.
Die Ergebnisse dieser Prüfungen sind in Tabelle 1 zusammengefaßt.

Die ausgehärtete Tinte 1 haftet excellent auf der Kupferoberfläche und ist mit den handelsüblichen Lösungsmitteln nicht abwischbar. Außerdem zeichnen sich die Beschriftungen durch eine hervorragende thermische Belastbarkeit aus.

Beispiel 2

Mit der Tinte 1 werden analog zu Beispiel 1 mit Hilfe des Farbstrahldruckers TSSG der Firma Wiedenbach selektiv die Leiterbahnen einer Leiterplatte beschichtet (Trockenfilmschichtdicke nach einmaligem Tintenauftrag 4 µm). Außerdem werden Spritzgußteile aus Polyamid und Keramikwiderstände analog zu Beispiel 1 selektiv beschichtet. Die Aushärtung der Tinte erfolgt mit Hilfe eines Heißluftgebläses (Leistung 2 kW; Temperatur der Heißluft 200 bis 400°C) innerhalb einer Zeit von 5 s.
Die so erhaltenen Beschichtungen haften gut auf den verschiedenen Oberflächen, sind mit den handelsüblichen Lösungsmitteln nicht ablösbar und zeigen eine sehr gute thermische Belastbarkeit. Die Prüfergebnisse sind in Tabelle 1 zusammengestellt.

Beispiel 3

130,7 g der obenbeschriebenen 25 %igen Lösung der Polyamidocarbonsäure werden mit 393,1 g N-Methylpyrrolidon verdünnt. 11,8 g Lithiumperchlorat Trihydrat werden in 65,5 g Propylencarbonat gelöst. 7,8 g eines handelsüblichen roten Xanthen-Farbstoffes (BASONYL® Rot 540 der Firma BASF AG, Ludwigshafen) werden in 391,1 g N-Methylpyrrolidon gelöst. Die drei Lösungen werden miteinander gemischt. Die so erhaltene rote Tinte 2 hat eine Viskosität von 8 mPas bei 23°C, einen Festkörper von 51 % (2 g/2 h/200°C) und eine Leitfähigkeit von 1460 µS/cm bei 25°C.
Mit dieser roten Tinte 2 werden analog zu Beispiel 1 mit Hilfe des Farbstrahldruckers TSSG der Firma Wiedenbach Keramikbauteile (Widerstände aus technischer Keramik), Glaskörper (Flaschen, Reflektoren) und PVC-Filme beschriftet. Die Aushärtung der Beschriftungen erfolgt analog Beispiel 2 mittels eines Heißluftgebläses (Leistung 2kW; Temperatur der Heißluft 200 bis 400°C) innerhalb von 5 s.

Die so erhaltenen roten Schriftzüge zeigen in allen Fällen eine hervorragende Beständigkeit gegenüber handelsüblichen Lösungsmitteln (Methylethylketon, Ethanol, Isopropanol, Freon® TP 35), eine sehr gute thermische Belastbarkeit (Prüfung analog Beispiel 1 und 2 b) sowie eine hervorragende Haftung (jeweils Note 0 im Tesafilm®-Abrißtest und keine Beschädigung der Beschriftung bei der Fingernagel-Ritzprüfung).

Beispiel 4

128,2 g der obenbeschriebenen 25 %igen Lösung der Polyamidocarbonsäurelösung werden mit 384,6 g N-Methylpyrrolidon verdünnt. 12,8 g Lithiumperchlorat Trihydrat werden in 64,1 g Propylencarbonat gelöst. 25,7 g eines handelsüblichen blauen Azofarbstoffes (FASTUSOL® Blau 31L der Firma BASF AG, Ludwigshafen) werden in 384,6 g N-Methylpyrrolidon gelöst. Die drei Lösungen werden anschließend miteinander gemischt.
Die so erhaltene blaue Tinte 3 hat bei 23°C eine Viskosität von 8 mPas und einen Festkörper von 5,6 % (2 g/2 h/200°C). Die Leitfähigkeit beträgt 1350 µS/cm.

Mit der so erhaltenen blauen Tinte 3 werden analog zu Beispiel 3 Keramikbauteile (Keramikwiderstände, Glaskörper (Flaschen, Reflektoren) PVC-Filme, Polyamidspritzgußteile (Steckverbindungen), Kupferbleche sowie Aluminiumbleche beschriftet. Die Aushärtung der Beschriftungen erfolgt ebenfalls analog Beispiel 3 mittels eines Heißluftgebläses (Leistung 2 kW; Temperatur der Heißluft 200 bis 400°C) während einer Zeit von 5 s.

Die so erhaltenen blauen Schriftzüge zeigen in allen Fällen eine sehr gute thermische Belastbarkeit (Prüfung analog Beispiel 1 und 2 b) sowie eine hervorragende Beständigkeit gegenüber handelsüblichen Lösungsmitteln (Methylethylketon, Ethanol, Isopropanol, Freon® TP 35). Bei der Prüfung der Beschriftung nach der Tesafilm®-Abrißmethode wurde keine Beschädigung der Beschriftung beobachtet, ebenso bei der Fingernagel-Ritzprobe.

Beispiel 5

197,6 g der obenbeschriebenen 25 %igen Lösung der Polyamidocarbonsäurelösung werden mit 350,0 g N-Methylpyrrolidon verdünnt. 2,0 g eines handelsüblichen blaugrünen Fluoreszenzfarbstoffs (Lumilux® Blaugrün CD 301 der Firma Riedel-de Haën) werden in 341,7 g N-Methylpyrrolidon gelöst. 9,9 g Lithiumperchlorat Trihydrat werden in 98,8 g Propylencarbonat gelöst. Die drei Lösungen werden miteinander gemischt. Die so erhaltene Tinte 4 hat eine Viskosität von 8 mPas bei 23°C, einen Festkörper von 6,2 % (2 g/2 h/200°C) und eine spezifische Leitfähigkeit von 1020 µS/cm.

Mit der so erhaltenen Tinte 4 werden analog zu Beispiel 3 Keramikbauteile (Keramikwiderstände), Glaskörper (Flaschen Reflektoren), PVC-Filme, Polyamidspritzgußteil (Steckverbindungen), Kupferbleche sowie Aluminiumbleche beschriftet. Die Aushärtung der Beschriftungen erfolgt ebenfalls analog Beispiel 3 mittels eines Heißluftgebläses (Leistung 2 kW; Temperatur der Heißluft 200 bis 400°C) während einer Zeit von 5 s.
Die so erhaltenen Schriftzüge zeigen in allen Fällen eine sehr gute thermische Belastbarkeit (Prüfung analog Beispiel 1 und 2 b) sowie eine hervorragende Beständigkeit gegenüber handelsüblichen Lösungsmitteln (Methylethylketon, Ethanol, Isopropanol, Freon® TP 35). Sowohl bei der Prüfung der Haftung nach der Tesafilm®-Abrißmethode als auch bei der Fingernagel-Ritzprüfung wurde keine Beschädigung der Beschriftung beobachtet. Außerdem weisen die Beschriftungen eine sehr gute thermische Belastbarkeit auf.

Die beschichteten Stellen fluoreszieren außerdem bei Bestrahlung mit einer UV-Lampe (abgestrahlte Wellenlänge 350 nm).

Tabelle 1

| Beispiel | 1 | 2 a | 2 b | 2 c |
|---|---|---|---|---|
| Untergrund | Kupfer | Keramik | Polyamid | Leiterplatte |
| Tesafilm®-Test | 0 | 0 | 0 | 0 |
| Fingernagel-Probe | i.O. | i. O. | i.O. | i.O. |
| Methylethylketon | i.O. | i.O. | i.O. | i.O. |
| Ethanol | i.O. | i.O. | i.O. | i.O. |
| Isopropanol | i.O. | i.O. | i.O. | i.O. |
| Freon® TP 35 | i.O. | i.O. | i.O. | i.O. |
| therm. Belastbarkeit | 240°C/ 10 h 1) | 240°C/ 10 h 1) | 400°C/ 1 min 2) | 400°C/ 0,5 min |
| | i.O. | i.O. | i.O. | i.O. |

1) Wärmeschrank
2) Heißluftgebläse, 20 cm Abstand

**Patentansprüche**

1. Tinte für das Strahldruckverfahren, enthaltend Bindemittel, organisches Lösungsmittel, Leitsalz, ggf. Pigmente und/oder Farbstoffe oder Fluoreszenzfarbstoffe sowie ggf. weitere Hilfs- und Zusatzstoffe, dadurch gekennzeichnet, daß sie

A) 1 bis 30 Gew.-% einer oder mehrerer Polyamidocarbonsäuren oder eines oder mehrerer in organischen Lösungsmitteln löslicher Polyimide,
B) 60 bis 98,8 Gew.-% mindestens eines organischen Lösungsmittels,
C) 0,1 bis 3 Gew.-% mindestens eines Leitsalzes,
D) ggf. Pigmente, Farbstoffe oder Fluoreszenzfarbstoffe und
E) ggf. weitere Hilfs- und Zusatzstoffe

enthält, wobei alle Mengenangaben auf das Gesamtgewicht der Tinte bezogen sind.

2. Tinte nach Anspruch 1, dadurch gekennzeichnet, daß sie
A) 2 bis 15 Gew.-% einer oder mehrerer Polyamidocarbonsäuren oder eines oder mehrerer in organischen Lösungsmitteln löslicher Polyimide,
B) 79,5 bis 97,6 Gew.-% mindestens eines organischen Lösungsmittels,
C) 0,2 bis 1,5 Gew.-% mindestens eines Leitsalzes,
D) ggf. Pigmente, Farbstoffe oder Fluoreszenzfarbstoffe und
E) ggf. weitere Hilfs- und Zusatzstoffe

enthält, wobei alle Mengenangaben auf das Gesamtgewicht der Tinte bezogen sind.

3. Tinte nach Anspruch 1 oder 2, dadurch gekennzeichnet, daß sie als Bindemittel Polyamidocarbonsäuren oder Polyimide auf der Basis von 4,4'-Diaminodiphenyloxid, Benzidin, Benzophenon-3,3', 4,4'-tetracarbonsäuredianhydrid und/oder Pyromellithsäureanhydrid enthält.

4. Tinte nach einem der Ansprüche 1 bis 3, dadurch gekennzeichnet, daß sie als Lösungsmittel N-Methylpyrrolidon und/oder Amide und/oder Alkylencarbonate der Formel

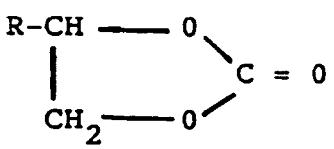

wobei R entweder H oder einen aliphatischen, aromatischen oder alkylaromatischen Rest darstellt, enthält.

5. Tinte nach einem der Ansprüche 1 bis 4, dadurch gekennzeichnet, daß sie eine Viskosität bei 23°C von 0,5 bis 90 mPas und eine spezifische Leitfähigkeit von 300 bis 20.000 µS/cm aufweist.

6. Verfahren zur Herstellung von Tinten für das Strahldruckverfahren, bei dem Bindemittel, organisches Lösungsmittel, Leitsalze, ggf. Pigmente, Farbstoffe oder Fluoreszenzfarbstoffe sowie ggf. weitere Hilfs- und Zusatzstoffe gemischt und ggf. durch Dispergieren homogenisiert werden, dadurch gekennzeichnet, daß die Tinten
A) 1 bis 30 Gew.-% einer oder mehrerer Polyamidocarbonsäuren oder eines oder mehrerer in organischen Lösungsmitteln löslicher Polyimide,
B) 60 bis 98,8 Gew.-% mindestens eines organischen Lösungsmittels,
C) 0,1 bis 3 Gew.-% mindestens eines Leitsalzes,
D) ggf. Pigmente, Farbstoffe oder Fluoreszenzfarbstoffe und
E) ggf. weitere Hilfs- und Zusatzstoffe,

wobei alle Mengenangaben auf das Gesamtgewicht der Tinte bezogen sind, enthalten.

7. Verfahren nach Anspruch 6, dadurch gekennzeichnet, daß
A) 2 bis 15 Gew.-% einer oder mehrerer Polyamidocarbonsäuren oder eines oder mehrerer in organischen Lösungsmitteln löslicher Polyimide,
B) 79,5 bis 97,6 Gew.-% mindestens eines organischen Lösungsmittels,
C) 0,2 bis 1,5 Gew.-% mindestens eines Leitsalzes,
D) ggf. Pigmente, Farbstoffe oder Fluoreszenzfarbstoffe und
E) ggf. weitere Hilfs- und Zusatzstoffe

gemischt und ggf. durch Dispergieren homogenisiert werden, wobei alle Mengenangaben auf das Gesamtgewicht bezogen sind.

8. Verfahren nach Anspruch 6 oder 7, dadurch gekennzeichnet, daß als Bindemittel Polyamidocarbonsäuren oder Polyimide auf der Basis von 4,4'-Diaminodiphenyloxid, Benzidin, Benzophenon-3,3'4,4'-tetracarbonsäuredianhydrid und/oder Pyromellithsäureanhydrid eingesetzt werden.

9. Verfahren nach einem der Ansprüche 6 bis 8, dadurch gekennzeichnet, daß als Lösungsmittel N-Methylpyrrolidon und/oder Amide und/oder Alkylencarbonate der Formel

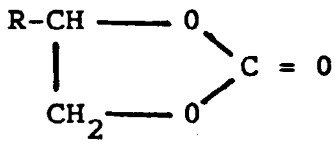

wobei R entweder H oder einen aliphatischen, aromatischen oder alkylaromatischen Rest darstellt, eingesetzt werden.

10. Verfahren zum Beschriften einer Oberfläche mittels des Strahldruckverfahrens, dadurch gekennzeichnet, daß eine Tinte nach einem der Ansprüche 1 bis 5 aufgebracht wird.

11. Verwendung der Tinte nach einem der Ansprüche 1 bis 5 zur Beschriftung thermisch und/oder chemisch belasteter Oberflächen.

## Claims

1. Ink for the jet printing process, containing binder, organic solvent, conducting salt, optionally pigments and/or dyestuffs or fluorescent dyestuffs and also optionally further auxiliaries and additives, characterized in that it contains
   A) 1 to 30% by weight of one or more polyamidocarboxylic acids or one or more polyimides soluble in organic solvents,
   B) 60 to 98.8% by weight of at least one organic solvent,
   C) 0.1 to 3% by weight of at least one conducting salt,
   D) optionally pigments, dyestuffs or fluorescent dyestuffs, and
   E) optionally further auxiliaries and additives,
   all the data on amounts being based on the total weight of the ink.

2. Ink according to Claim 1, characterized in that it contains
   A) 2 to 15 % by weight of one or more polyamidocarboxylic acids or one or more polyimides soluble in organic solvents,
   B) 79.5 to 97.6 % by weight of at least one organic solvent,
   C) 0.2 to 1.5 % by weight of at least one conducting salt,
   D) optionally pigments, dyestuffs or fluorescent dyestuffs, and
   E) optionally further auxiliaries and additives,
   all the data on amounts being based on the total weight of the ink.

3. Ink according to Claim 1 or 2, characterized in that it contains polyamidocarboxylic acids or polyimides based on 4,4'-diaminodiphenyl oxide, benzidine, benzophenone-3,3', 4,4'-tetracarboxylic dianhydride and/or pyromellitic anhydride as binder.

4. Ink according to any of Claims 1 to 3, characterized in that it contains N-methylpyrrolidone and/or amides and/or alkylene carbonates of the formula

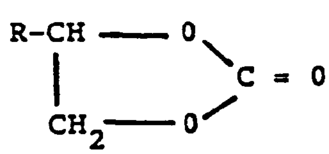

as solvent, where R is either H or an aliphatic, aromatic or alkylaromatic radical.

**5.** Ink according to any of Claims 1 to 4, characterized in that it has a viscosity of 0.5 to 90 mPa.s at 23°C and a specific conductivity of 300 to 20,000 µS/cm.

**6.** Process for producing inks for the jet printing process in which binder, organic solvent, conducting salt, optionally pigments, dyestuffs or fluorescent dyestuffs and also optionally further auxiliaries and additives are mixed and optionally homogenized by dispersion, characterized in that the inks contain
A) 1 to 30 % by weight of one or more polyamidocarboxylic acids or one or more polyimides soluble in organic solvents,
B) 60 to 98.8 % by weight of at least one organic solvent,
C) 0.1 to 3 % by weight of at least one conducting salt,
D) optionally pigments, dyestuffs or fluorescent dyestuffs, and
E) optionally further auxiliaries and additives, all the data on amounts being based on the total weight of the ink.

**7.** Process according to Claim 6, characterized in that
A) 2 to 15 % by weight of one or more polyamidocarboxylic acids or one or more polyimides soluble in organic solvents,
B) 79.5 to 97.6 % by weight of at least one organic solvent,
C) 0.2 to 1.5 % by weight of at least one conducting salt,
D) optionally pigments, dyestuffs or fluorescent dyestuffs, and
E) optionally further auxiliaries and additives
are mixed and optionally homogenized by dispersion, all the data on amounts being based on the total weight.

**8.** Process according to Claim 6 or 7, characterized in that polyamidocarboxylic acids or polyimides based on 4,4′-diaminodiphenyl oxide, benzidine, benzophenone-3,3′4,4′-tetracarboxylic dianhydride [sic] and/or pyromellitic anhydride are used as binder.

**9.** Process according to any of Claims 6 to 8, characterized in that N-methylpyrrolidone and/or amides and/or alkylene carbonates of the formula

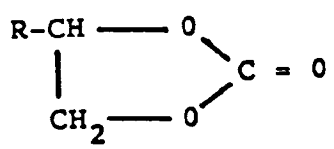

are used as solvent, where R is either H or an aliphatic, aromatic or alkylaromatic radical.

**10.** Process for inscribing a surface by means of the jet printing process, characterized in that an ink according to any of Claims 1 to 5 is applied.

**11.** Use of the ink according to any of Claims 1 to 5 for inscribing thermally and/or chemically stressed surfaces.

## Revendications

**1.** Encre pour le procédé d'impression par jet d'encre, contenant un liant, un solvant organique, un sel conducteur, éventuellement des pigments et/ou des colorants ou des colorants de fluorescence ainsi qu'éventuellement des additifs et adjuvants supplémentaires, caractérisée en ce qu'elle contient
(A) de 1 à 30 % en poids d'un ou de plusieurs acides carboxyliques polyamides ou d'un ou de plusieurs polyimides solubles dans des solvants organiques,
(B) de 60 à 98,8 % en poids d'au moins un solvant organique,
(C) de 0,1 à 3 % en poids d'au moins un sel conducteur,
(D) éventuellement des pigments, des colorants ou des colorants de fluorescence et
(E) éventuellement des additifs et adjuvants supplémentaires,
toutes les indications de quantité se rapportant au poids total de l'encre.

2. Encre selon la revendication 1, caractérisée en ce qu'elle contient
   (A) de 2 à 15 % en poids d'un ou de plusieurs acides carboxyliques polyamides ou d'un ou de plusieurs polyimides solubles dans des solvants organiques,
   (B) de 79,5 à 97,6 % en poids d'au moins un solvant organique,
   (C) de 0,2 à 1,5 % en poids d'au moins un sel conducteur,
   (D) éventuellement des pigments, des colorants ou des colorants de fluorescence et
   (E) éventuellement des additifs et adjuvants supplémentaires,

   toutes les indications de quantité se rapportant au poids total de l'encre.

3. Encre selon la revendication 1 ou 2, caractérisée en ce qu'elle contient en tant que liant des acides carboxyliques polyamides ou des polyimides à base d'oxyde de 4,4′-diaminophényle, de benzidine, de dianhydride d'acide benzophénone-3,3′,4,4′-tétracarboxylique et/ou d'anhydride d'acide pyromellique.

4. Encre selon l'une des revendications 1 à 3, caractérisée en ce qu'elle contient en tant que solvant de la N-méthylpyrrolidone et/ou des amides et/ou des carbonates d'alkylènes de formule

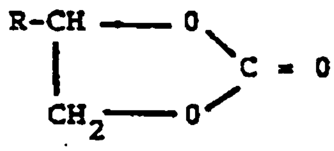

   dans laquelle R représente soit H, soit un radical aliphatique, aromatique ou alkylaromatique.

5. Encre selon l'une quelconque des revendications 1 à 4, caractérisée en ce qu'elle présente une viscosité à 23°C de 0,5 à 90 mPas et une conductivité spécifique de 300 à 20 000 µS/cm.

6. Procédé de fabrication d'encres pour l'impression par jet d'encre, lors duquel on mélange et on homogénéise éventuellement par dispersion liant, solvant organique, sel conducteur, éventuellement des pigments, des colorants ou des colorants de fluorescence ainsi qu'éventuellement des additifs et adjuvants supplémentaires, caractérisé en ce que les encres contiennent
   (A) de 1 à 30 % en poids d'un ou de plusieurs acides carboxyliques polyamides ou d'un ou de plusieurs polyimides solubles dans des solvants organiques,
   (B) de 60 à 98,8 % en poids d'au moins un solvant organique,
   (C) de 0,1 à 3 % en poids d'au moins un sel conducteur,
   (D) éventuellement des pigments, des colorants ou des colorants de fluorescence et
   (E) éventuellement des additifs et adjuvants supplémentaires,

   toutes les indications de quantité se rapportant au poids total de l'encre.

7. Procédé selon la revendication 6, caractérisé en ce que l'on mélange et qu'on homogénéise éventuellement par dispersion
   (A) de 2 à 15 % en poids d'un ou de plusieurs acides carboxyliques polyamides ou d'un ou de plusieurs polyimides solubles dans des solvants organiques,
   (B) de 79,5 à 97,6 % en poids d'au moins un solvant organique,
   (C) de 0,2 à 1,5 % en poids d'au moins un sel conducteur,
   (D) éventuellement des pigments, des colorants ou des colorants de fluorescence et
   (E) éventuellement des additifs et adjuvants supplémentaires,

   toutes les indications de quantité se rapportant au poids total de l'encre.

8. Procédé selon la revendication 6 ou 7, caractérisé en ce que l'on utilise en tant que liant des acides carboxyliques polyamides ou des polyimides à base d'oxyde de 4,4′-diaminophényle, de benzidine, de dianhydride d'acide benzophénone-3,3′,4,4′-tétracarboxylique et/ou d'anhydride d'acide pyromellique.

9. Procédé selon l'une des revendications 6 à 8, caractérisé en ce que l'on utilise en tant que solvant de la N-méthylpyrrolidone et/ou des amides et/ou des carbonates d'alkylènes de formule

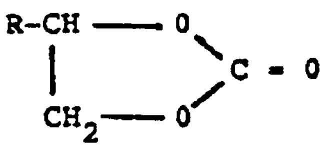

dans laquelle R représente soit H, soit un radical aliphatique, aromatique ou alkylaromatique.

10. Procédé d'inscription d'une surface à l'aide du procédé d'impression par jet d'encre, caractérisé en ce que l'on applique une encre selon l'une des revendications 1 à 5.

11. Utilisation de l'encre selon l'une des revendications 1 à 5 pour l'inscription de surfaces soumises à exposition thermique ou chimique.